Europäisches Patentamt

(19) European Patent Office

Office européen des brevets

(11) Numéro de publication: **0 003 270**
**B1**

(12) **FASCICULE DE BREVET EUROPEEN**

(45) Date de publication du fascicule de brevet: **02.09.81**

(51) Int. Cl.³: **H 01 L 21/603**

(21) Numéro de dépôt: **78400231.3**

(22) Date de dépôt: **12.12.78**

(54) **Procédé de réalisation de connexions d'un dispositif semiconducteur et appareil pour sa mise en oeuvre.**

(30) Priorité: **20.12.77 FR 7738394**

(43) Date de publication de la demande:
**08.08.79 Bulletin 79/16**

(45) Mention de la délivrance du brevet:
**02.09.81 Bulletin 81/35**

(84) Etats Contractants Désignés:
**DE IT**

(56) Documents cités:
**US - A - 3 623 649**

(73) Titulaire: **THOMSON-CSF**
**173, Boulevard Haussmann**
**F-75360 Paris Cedex 08 (FR)**

(72) Inventeur: **Gailland, Gilbert**
**"THOMSON-CSF" - SCPI 173, bld Haussmann**
**F-75360 Paris Cedex 08 (FR)**

(74) Mandataire: **Favre, Maurice et al,**
**"THOMSON-CSF" - SCPI 173, bld Haussmann**
**F-75360 Paris Cedex 08 (FR)**

Courier Press, Leamington Spa, England.

# Procédé de réalisation de connexions d'un dispositif semiconducteur et appareil pour sa mise en oeuvre

La présente invention se rapporte au domaine de la soudure de fils de connexion électrique sur des bornes ou cosses métalliques.

Dans un certain nombre de dispositifs ou appareils électriques, il est nécessaire de relier les électrodes de la partie active de ces dispositifs à des bornes conductrices supportées par un support d'ensemble isolant ou embase, permettant par leur forme, leurs dimensions et leur robustesse un raccordement aisé avec les circuits extérieurs. Chaque borne présente ainsi une partie externe pour assurer ce raccordement, et une partie interne, conçue pour être reliée à une des électrodes du dispositif fixé sur l'embase. C'est par l'intermédiaire d'un fil conducteur souple que cette liaison est fréquemment assurée, la partie interne de la borne présentant une partie plane ou "cosse", sur laquelle le fil est appliqué, et habituellement soudé par une de ses extrémités.

Cependant, la mise en oeuvre d'un tel moyen de raccordement, aisée dans le cas général des circuits électriques de dimensions courantes, devient de plus en plus difficile lorsque les dimensions des éléments à relier diminuent, en particulier dans le cas où les dispositifs à raccorder adoptent l'échelle des circuits de la micro-électronique, souvent réalisés, de plus, sur un bloc unique de matériau semiconducteur.

L'association des éléments à raccorder fait alors le plus souvent appel, pour sa réalisation, à une embase, ou socle isolant, supportant le bloc de matériau semiconducteur, l'une et l'autre portant, sur leur pourtour externe, respectivement pour la première des bornes à cosse, et pour le second des électrodes de contact, reliées aux diverses parties du circuit existant sur le bloc.

Le fil conducteur est délivré de façon continue, à l'extrémité d'un guide en forme de tube dans l'intérieur duquel il est introduit, et dont il sort à une extrémité utile; le brin de fil ainsi libéré est alternativement appliqué, par la face de sortie du tube, avec une pression et une température prédéterminées, sur les cosses et les électrodes de contact, où il se trouve fixé par soudage, et est, après chaque application, coupé pour permettre l'exécution de l'opération de raccordement suivante. Cette coupure est réalisée en mettant à profit l'écrasement partiel subi par le fil dans la région de soudage, qui y affaiblit considérablement la résistance mécanique; une force de traction modérée exercée sur le brin de fil présent dans le tube de guidage suffit alors à assurer la coupure du fil au niveau même du point de soudure.

Cependant, ainsi qu'il sera expliqué plus loin en détail, en s'appuyant sur des figures explicatives, un tel procédé exige que la force d'application du fil sur la cosse, qui détermine à la fois la bonne exécution du soudage et l'écrasement partiel du fil, soit réglée avec une grande précision. Cette exigence conduit à la nécessité de mise en oeuvre d'un dispositif de commande des déplacements du tube de guidage extrêmement précis, qui puisse assurer, à la face de sortie du tube, un écrasement déterminé du fil satisfaisant aux conditions indiquées ci-dessus. Or le fil de connexion utilisé est d'un très petit diamètre, typiquement compris entre 20 et 50 $\mu$ et le tube de guidage du fil dont la face de sortie assure le soudage est typiquement d'un diamètre extérieur de 200 $\mu$; pour cette raison, il est souvent désigné sous le terme de "tube capillaire". La distance à ménager entre la face de sortie du tube et la surface de la cosse est donc très faible, typiquement de l'ordre de la moitié du diamètre du fil, soit d'environ 10 à 30 $\mu$.

En pratique c'est le fil lui-même qui constitue l'unique cale d'épaisseur définissant la distance à ménager, lorsqu'il atteint son épaisseur finale après écrasement. La définition de la distance correspondante est, dans ces conditions, très imprécise, puisque, pour une force d'application constante, elle dépend du diamètre du fil et de la nature du matériau dont il est constitué.

Pour pallier ces inconvénients, le brevet américain 3 623 649 propose un dispositif dans lequel le plan d'extrémité du tube capillaire est muni d'une rainure. Toutefois, ce dispositif parait relativement complexe et peu adapté à des fils de très petite section.

Un objet de la présente invention est de résoudre ce problème de façon simple et adaptée à des fils de très petite section.

Plus précisément, l'invention se rapporte à un procédé de réalisation de connexions d'un dispositif semiconducteur sur embase, chacune de ces connexions étant constituée par un fil dont une extrémité est en liaison avec le dispositif et l'autre doit être soudée à une cosse faisant partie d'un élément de contact solidaire de l'embase, ce fil étant préalablement introduit dans un outil en forme de tube ouvert ou "capillaire" sur une face terminale plane duquel il débouche, en formant d'une part un brin intérieur logé dans le capillaire, et d'autre part un brin extérieur, dont la direction est définie par la liaison de ladite extrémité avec le dispositif semiconducteur, procédé comportant les étapes suivantes:

—guidage du fil par déplacement de la face terminale plane sur la région de soudure plane de la surface de la cosse,

—soudure du fil sur cette région, par serrage à chaud du fil entre cette région et une portion de la face terminale,

—entaillage partiel, par écrasement limité du brin intérieur du fil au voisinage de la soudure,

—sectionnement du fil par application d'une force de traction sur le brin intérieur,
ce procédé étant caractérisé en ce que les deux plans correspondant respectivement à la face terminale du capillaire et à la surface de la cosse font un angle déterminé, dont l'arête est située sur une partie commune de contact lors de l'étape d'entaillage.

L'invention sera mieux comprise à l'aide de la description ci-après, en s'appuyant sur les figures annexées, où:

— la figure 1 représente, sous forme d'un dessin explicatif, la structure connue d'un dispositif d'encapsulation avec connexions du type connu;

— la figure 2 représente les étapes de soudage d'une connexion sur une cosse d'un tel dispositif;

— la figure 3 représente un mode de mise en oeuvre connu d'un procédé de soudage;

— la figure 4 représente, sous forme explicative, un premier mode de mise en oeuvre de procédé de l'invention;

— la figure 5 représente une variante de ce premier mode;

— les figures 6 et 7 représentent des modes de réalisation de cosses permettant la mise en oeuvre de l'invention;

— la figure 8 représente un mode de réalisation d'un tube capillaire permettant la mise en oeuvre de l'invention.

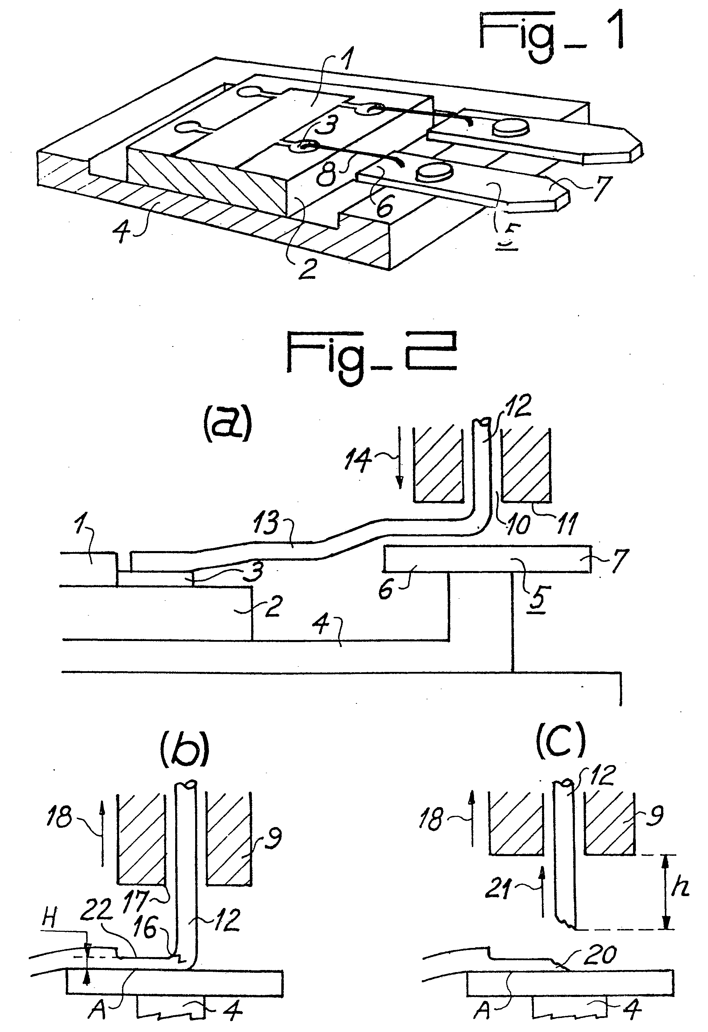

La figure 1 représente, sous forme d'un dessin explicatif, la structure connue d'un dispositif d'encapsulation d'un circuit de micro-électronique.

Le circuit 1, réalisé, sur un bloc semiconducteur 2 est fixé sur une embase 4 constituée d'un matériau isolant, et comporte une pluralité d'électrodes de sortie telles que 3.

L'embase supporte elle-même une pluralité de bornes telles que 5, chacune d'elles comportant une partie interne 6 ou ''cosse'', et une partie externe 7 ou patte de connexion.

Un fil conducteur d'un diamètre et d'un matériau choisis pour lui conférer une souplesse élevée, assure la liaison électrique entre chaque électrode 3 et la cosse correspondante 6. Ainsi est assurée la protection du circuit lui-même contre les efforts mécaniques extérieurs sur les connexions, un couvercle non représenté étant fixé ensuite sur l'embase pour assurer la protection contre les atteintes de l'environnement.

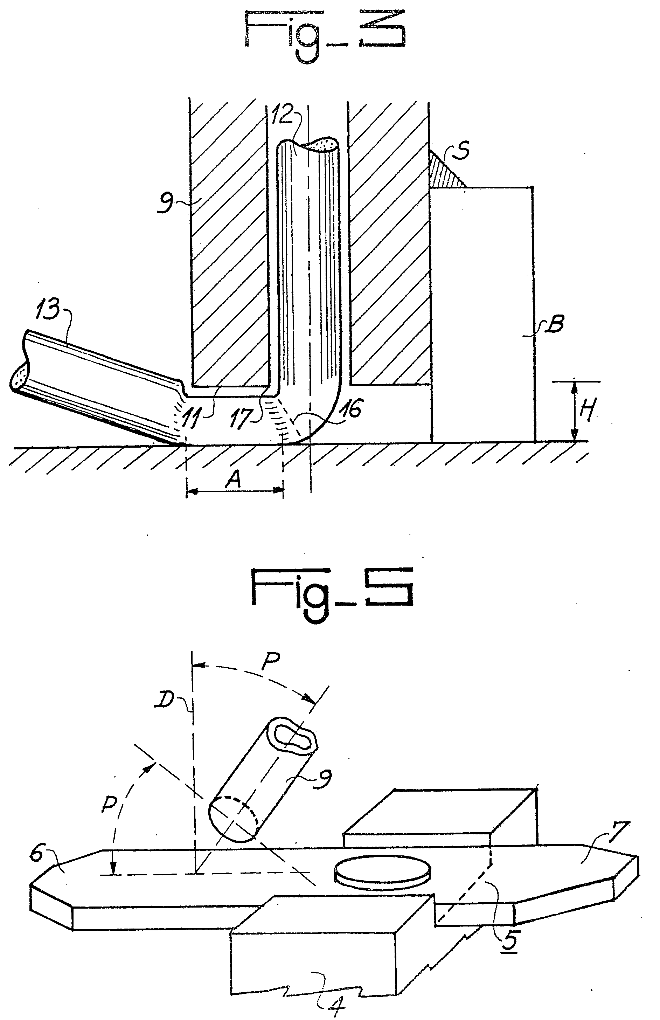

La figure 2 représente, en coupe, sur des dessins (a) (b) (c) trois étapes de la réalisation pratique du raccordement d'un circuit semiconducteur sur les cosses d'une embase. Les mêmes éléments portant les mêmes nombres-repères que sur la figure 1, le procédé connu met en oeuvre un tube 9, présentant un canal interne 10, et une face terminale 11, dont le rôle est fondamental. Compte tenu de ses très petites dimensions, typiquement un diamètre intérieur de 70 micromètres, ce tube sera désigné dans toute la suite sous le nom de ''tube capillaire''.

Le fil de connexion est introduit de façon continue dans le canal, où il constitue le brin intérieur d'alimentation 12, et débouche sur la face terminale d'ou il s'étend à l'extérieur, où il constitue le brin extérieur de raccordement 13.

Ce brin ayant été préalablement soudé sur l'électrode 3, le procédé comporte une première étape de soudure, où le tube capillaire 9 est déplacé, par un mécanisme non représenté, suivant le sens de la flèche 14, sa face terminale, parallèle à la surface de la cosse, se rapprochant ainsi de cette dernière, en réalisant un serrage du fil 13, du type à mâchoires parallèles.

Ce serrage s'effectue à chaud et sous pression, dans des conditions connues telles que, compte tenu de la nature des matériaux du fil et de la cosse, un soudage entre le fil et la cosse en résulte, sur une longueur A. Suivant des valeurs typiques, entre un fil de 25 $\mu$ et une cosse de 300 $\mu$ une température de 350° C sous une force de 80gr est satisfaisante.

Le fil présente alors un écrasement 22, d'épaisseur constante H sur toute la longueur de sa partie soudée, comme représenté en figure 2(b).

Cependant, un second résultat est obtenu en continuant le mouvement du capillaire dans le sens de la flèche 14: pour une valeur convenable du déplacement, le métal du fil subit un écrasement qui dépasse ses possibilités de ductilité, et une amorce de rupture ou cassure est alors avantageusement produite par la face terminale du capillaire, en une région 16 voisine du brin intérieur 12.

Dans une deuxième étape, le capillaire 9 est écarté, suivant la flèche 18, de la surface de la cosse, libérant une longueur donnée du brin intérieur 12.

Quand cette longueur atteint une valeur considérée comme suffisante h, une traction est exercée dans le même sens 21 sur le fil 12, et, par suite de la présence de l'amorce de rupture 16, un sectionnement du fil se produit en 20, comme en figure 2(c).

La longueur h de fil devient alors un brin extérieur pour une nouvelle opération de raccordement, et le procédé peut être à nouveau mis en oeuvre selon une nouvelle suite d'étapes comme on vient de le décrire.

Il est essentiel, dans la pratique industrielle, que cette troisième étape ait lieu, à savoir d'abord la libération, à l'extérieur du capillaire, d'une longueur donnée du brin intérieur, et ensuite le sectionnement du fil, au niveau de l'amorce de rupture provoquée à la fin de la première étape. En effet, soit le sectionnement prématuré avant libération, soit la libération sans sectionnement, conduisent l'un et l'autre à une disparition finale du brin extérieur, conduisant à la nécessité de reprendre une nouvelle extrémité de fil sur sa bobine débitrice, et de l'introduire dans le canal du capillaire. Cet incident, nommé ''perte de fil'', entraîne en fabrication des pertes de temps, et par conséquent d'argent, considérables.

Or le bon aboutissement de la troisième étape est lié à la résistance mécanique du fil après écrasement, qui dépend de la distance résiduelle laissée entre d'une part la face terminale du capillaire et d'autre part la surface de la cosse, lors du serrage du fil déterminant l'amorce de rupture. Et le procédé connu décrit plus haut fait uniquement appel, pour régler cette distance, à la présence du fil, et plus précisément à son degré d'écrasement lors de l'étape de soudure.

Or il n'y a aucune corrélation pratique entre ces deux notions, et, dans les équipements mécaniques où est mis en oeuvre le procédé, la nécessité d'obtenir une soudure de bonne qualité conduit à des pressions appliquées, donc à des écrasements de fil, entraînant souvent un sectionnement prématuré du fil avant formation d'un nouveau brin extérieur, sectionnement dont les conséquences néfastes ont été exposées plus haut.

La figure 3 représente, suivant une vue en coupe un tube capillaire équipé d'un moyen assurant l'obtention d'une distance de serrage optimale, suffisante pour déterminer une amorce de rupture dans la zone de cassure, mais insuffisante pour provoquer une rupture prématurée avant la formation complète du brin extérieur, exigence dont on a exposé l'importance plus haut.

Ce moyen consiste en un bloc B formant butée, solidaire du capillaire par un moyen tel que de la soudure S, et faisant saillie d'une longueur H par rapport à la face terminale de celui-ci.

Lors de la deuxième étape, cette butée vient s'appuyer sur la surface de la cosse, laissant subsister entre elle et la face terminale du capillaire qui lui est parallèle, une distance H de serrage satisfaisant aux conditions exposées plus haut. La détermination de cette distance, et donc la longueur dont la butée B doit faire saillie, ne peut être faite que par voie expérimentale, puisqu'elle dépend de nombreux facteurs, tels que le diamètre du fil, le matériau dont il est constitué, son état physicochimique, tel que l'écrouissage, la température, la résistance mécanique de la soudure réalisée à l'étape précédente, et la surface même de la face terminale.

Cependant, une telle solution, utilisable dans le cas d'une échelle de dimensions habituelles dans l'industrie, devient impraticable à l'échelle de la micro-électronique, où la distance H est typiquement de l'ordre de 10 micromètres.

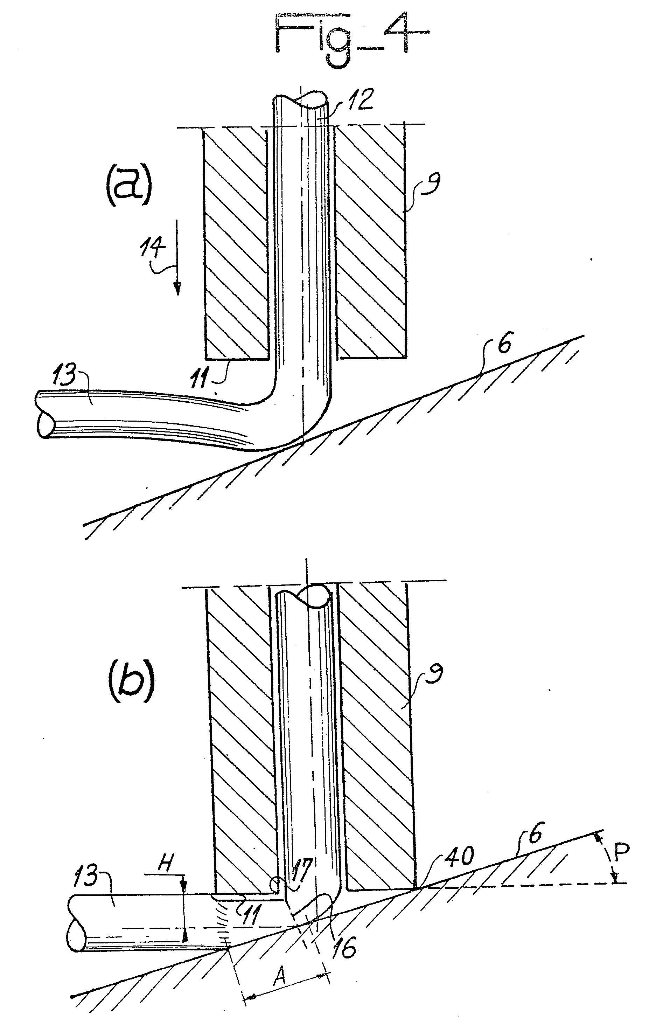

La figure 4 représente, sous forme explicative, un mode de mise en oeuvre du procédé selon l'invention.

Selon ce mode, et d'autres qui seront décrits plus loin, la deuxième étape décrite plus haut comporte la mise en oeuvre de moyens réalisant la mise en butée du capillaire sur la surface de la cosse, moyens simples parfaitement adaptés à l'échelle de la micro-électronique, et dont la présence ne modifie pas la nature et la succesion des étapes précédentes.

Le moyen, illustré sur la figure 4, réalise la mise en butée par la réalisation d'un angle différent de zéro entre les faces de serrage respectivement portées par l'extrémité du capillaire et la cosse à souder. La région de la face terminale du capillaire orientée vers le sommet de l'angle entre, à la fin de l'étape de soudure, en contact, en 40, avec la surface de la cosse, réalisant ainsi la même fonction que la butée B représentée sur la figure 2, mais sans en présenter les inconvénients et difficultés de réalisation.

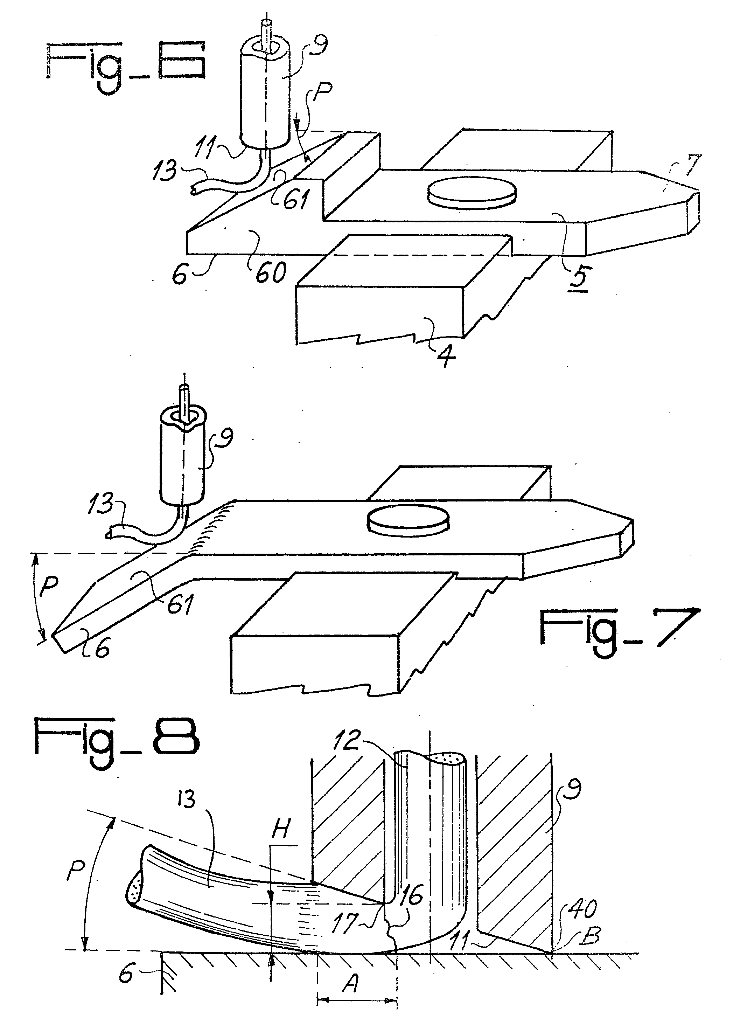

La figure 5 représente un premier mode de mise en oeuvre du procédé selon l'invention.

L'embase 4 du circuit à souder, représentée partiellement, porte une cosse à souder 5 de la manière connue. Par contre, le capillaire de soudage 9 a subi une inclinaison d'angle P par rapport à la droite perpendiculaire D au plan de la face de soudage de la cosse. Cette mise en oeuvre entraine une modification du dispositif de déplacement du capillaire pour permettre l'inclinaison prévue.

Les figures 6 et 7 représentent deux autres modes de mise en oeuvre de l'invention.

Selon ces modes, l'équipement de soudage tel que déjà représenté sur la figure 1 n'est pas modifié. Par contre, ce sont les cosses ellesmêmes qui supportent les modifications dues à l'invention.

Suivant la figure 6, la cosse 6 présente, à l'une de ses extrémités à souder, une portion 60 présentant un plan incliné 61, sur lequel le fil 13 peut être soudé, comme expliqué sur la figure 4, par application de la face de soudage 11 du capillaire 9.

Suivant la figure 7, la cosse 6 présente une disposition particulièrement simple, à savoir que le plan incliné 61 nécessaire à la mise en oeuvre du procédé de l'invention est réalisé par pliage partiel de l'extrémité de la cosse.

La figure 8 représente un autre mode avantageux de mise en oeuvre de procédé selon l'invention.

Le mode de mise en oeuvre décrit sur les figures précédentes conduit en effet à apporter des modifications, quelquefois compliquées, soit à l'équipement mécanique de soudure, en le dotant de dispositifs supplémentaires assurant l'obtention d'angles particuliers différents de 90° entre le plan de l'embase et l'axe du tube capillaire, soit aux cosses elles mêmes des embases, en leur conférant des caractéristiques géométriques ou des structures différentes des cosses habituelles rencontrées dans les applications.

Selon cet autre mode, l'équipement de soudure assure, dans des conditions déjà décrites et connues, le déplacement du capillaire perpendiculairement à la surface de la cosse à souder, cosse de type connu et n'ayant subi aucune opération de pliage particulière. Par contre, l'extrémité 11 du capillaire a subi une opération d'usinage conférant à· sa face terminale un angle P par rapport au plan perpendiculaire à la direction de déplacement de celui-ci. La butée assurant la distance de serrage optimal H est alors réalisée, d'une façon particulièrement avantageuse par sa simplicité, par la région de la face terminale proche du sommet B de l'angle P. Il est à remarquer que, au cours de la pluralité des soudures sur cosses à réaliser pour une embase de circuit micro-électronique, la partie B devra toujours être diamétralement opposée à la direction définie par le brin du fil déjà relié à l'électrode correspondante du circuit; cette orientation conduit à ce que l'équipement de soudure soit muni de moyens assurant la rotation du capillaire autour de son axe, en fonction de cette direction.

Un autre avantage résulte du mode de réalisation de la figure 8, lié au fait que l'angle optimal de la face terminale du capillaire par rapport au plan perpendiculaire à son axe dépend du diamètre du fil et du matériau dont il est constitué. Or, le mode de réalisation du capillaire suivant la figure 8 permet le soudage d'une grande variété de fils de caractéristiques différentes, par simple changement du capillaire correspondant, dans une gamme comportant des angles de face de sortie de valeurs échelonnées.

Dans le cas où les cosses sont réalisées suivant la mise en oeuvre des figures 6 ou 7, la combinaison entre une valeur d'angle particulière de la cosse et une autre valeur particulière du capillaire, permet d'étendre encore les possibilités de soudage de fils de caractéristiques très différentes.

Les modes de mise en oeuvre du procédé de soudure selon l'invention décrits et illustrés ci-dessus n'ont été donnés qu'à titre d'exemple. Tout autre mode de mise en oeuvre comprenant la caractéristique fondamentale de l'invention, à savoir la mise en contact, pendant l'étape de soudure, d'une partie de la face terminale du capillaire avec la surface de la cosse à souder, ladite mise en contact déterminant un écartement donné entre cette surface et une autre partie de la face terminale du capillaire, est compris dans le domaine de l'invention.

## Revendications

1. Procédé de réalisation de connexions d'un dispositif semiconducteur (2) sur embase (4), chacune de ces connexions étant constituée par un fil (8) dont une extrémité est en liaison avec le dispositif et l'autre doit être soudée à une cosse (6) faisant partie d'un élément de contact solidaire de l'embase, ce fil étant préalablement introduit dans un outil en forme de tube ouvert (9) ou "capillaire" sur une face terminale plane (11) duquel il débouche, en formant d'une part un brin intérieur (12) logé dans le capillaire, et d'autre part un brin extérieur (13), dont la direction est définie par la liaison de ladite extrémité avec le dispositif semiconducteur, procédé comportant les étapes suivantes:

—guidage du fil par déplacement de la face terminale plane sur la région de soudure plane de la surface de la cosse (6),

—soudure du fil sur cette région par serrage à chaud du fil entre cette région et une portion de la face terminale (11),

—entaillage partiel (16), par écrasement limité du brin intérieur du fil au voisinage de la soudure,

—sectionnement du fil par application d'une force de traction sur le brin intérieur,

ce procédé étant caractérisé en ce que l'écrasement est limité par le fait que les deux plans correspondant respectivement à la face terminale (11) du capillaire (9) et à la surface de la cosse (6) font un angle déterminé (P), dont l'arête est située sur une partie commune de contact (40) lors de l'étape d'entaillage.

2. Procédé selon la revendication 1, caractérisé en ce que l'axe du capillaire et sa face terminale sont respectivement perpendiculaires.

3. Procédé selon la revendication 1, caractérisé en ce que la face terminale du capillaire et le plan perpendiculaire à son axe font ledit angle déterminé.

4. Procédé selon la revendication 2, caractérisé en ce que la surface de la cosse fait ledit angle déterminé avec le plan de l'embase.

5. Procédé selon la revendication 2, caractérisé en ce que la face terminale du capillaire fait, lors de l'étape d'entaillage, ledit angle déterminé avec le plan de l'embase.

6. Appareil de réalisation de connexions d'un dispositif semiconducteur sur embase, caractérisé en ce qu'il assure la mise en oeuvre du procédé selon l'une des revendications précédentes.

## Claims

1. Method of producing connections of a semiconductor device (2) on a base member (4), each of said connections being formed of a wire (8) one end of which is in connection with the device and the other of which is to be soldered to a tag (6) forming part of a contact member secured on a said base member, said wire being previously introduced into a tool having the shape of an open or capillary tube (9) on one plane end face (11) of which it projects, forming an inner section (12) within the capillary tube and an outer section (13) the direction of which is defined by the connection of said end with the semiconductor device, the method comprising the following steps:

—guiding the wire by displacing the plane end face on the plane soldering region of the surface of the tag (6),

—soldering the wire on this region by hot squeezing of the wire between this region and a portion of the end face (11),
—partial cutting (16) by limited compression of the inner section of the wire in the neighbourhood of the soldering location,
—sectioning the wire by applying a traction force on the inner section,
the method being characterized in that the compression is limited by the fact that the two planes corresponding to the end face (11) of the capillary tube (9) and the surface of the tag (6), respectively, form a determined angle (P) the edge of which lies on a common contact portion (40) during the cutting step.

2. Method of claim 1, characterized in that the axis of the capillary tube and its end face are perpendicular to each other.

3. Method of claim 1, characterized in that the end face of the capillary tube and the plane perpendicular to its axis form the said determined angle.

4. Method of claim 2, characterized in that the surface of the tag forms the said determined angle with the plane of the base member.

5. Method of claim 2, characterized in that the end face of the capillary tube forms the said determined angle with the plane of the base member during the cutting step.

6. Apparatus for producing connections of a semiconductor device on a base member, characterized in that it assures the performance of the method of any of the preceding claims.

## Patentansprüche

1. Verfahren zur Herstellung von Anschlüssen an einer Halbleitervorrichtung (2) auf einem Sockel (4), wobei jeder dieser Anschlüsse gebildet ist aus einem Draht (8), dessen eines Ende mit der Vorrichtung in Verbindung ist und dessen anderes Ende mit einer Lötfahne (6) zu verlöten ist, die einen Teil eines mit dem Sockel fest verbundenen Kontaktelementes bildet, wobei dieser Drahr zuvor in ein Werkzeug eingeführt wird, das die Form eines offenen Rohres (9) oder einer "Kapillare" aufweist, an dessen ebener Abschlußfläche (11) er austritt, indem er einerseits einen sich innerhalb der Kapillare be-

findenden Innenabschnitt (12) und andererseits einen Außenabschnitt (13) bildet, dessen Richtung durch die Verbindung des genannten Endes mit der Halbleitervorrichtung definiert ist, wobei das Verfahren folgende Schritte umfaßt:
—Führung des Drahtes durch Verschiebung der ebenen Abschlußfläche über den ebenen Lötbereich der Oberfläche der Lötfahne (6),
—Verlöten des Drahtes auf diesem Bereich durch Einspannen des Drahtes unter Hitzeeinwirkung zwischen diesem Bereich und einem Teil der Abschlußfläche (11),
—teilweises Einschneiden (16) durch begrenztes Quetschen des Innenabschnittes des Drahtes in der Nähe der Lötstelle,
—Abtrennen des Drahtes durch Ausüben einer Zugspannung auf den Innenabschnitt,
wobei dieses Verfahren dadurch gekennzeichnet ist, daß das Quetschen durch den Umstand begrenzt ist, daß die zwei Ebenen, welche der Abschlußfläche (11) der Kapillare (9) bzw. der Oberfläche der Lötfahne (6) entsprechen, einen bestimmten Winkel (P) bilden, dessen Scheitel sich während des Verfahrensschrittes des Einschneidens an einem gemeinsamen Berührungsteil (40) befindet.

2. Verfahren nach Anspruch 1, dadurch gekennzeichnet, daß die Achse der Kapillare und ihre Abschlußfläche zueinander rechtwinkelig sind.

3. Verfahren nach Anspruch 1, dadurch gekennzeichnet, daß die Abschlußfläche der Kapillare und die zu ihrer Achse senkrechte Ebene den vorbestimmten Winkel miteinander bilden.

4. Verfahren nach Anspruch 2, dadurch gekennzeichnet, daß die Oberfläche der Lötfahne den vorbestimmten Winkel mit der Ebene des Sockels bildet.

5. Verfahren nach Anspruch 2, dadurch gekennzeichnet, daß die Abschlußfläche der Kapillare bei dem Verfahrensschritt des Einschneidens den bestimmten Winkel mit der Sockelebene bildet.

6. Gerät zur Herstellung von Anschlüssen einer Halbleitervorrichtung auf einem Sockel, dadurch gekennzeichnet, daß es die Durchführung des Verfahrens nach einem der vorstehenden Ansprüche ermöglicht.

0 003 270

Fig_1

Fig_2

(a)

(b)

(C)

Fig_3

Fig_5

0 003 270

# Fig_4

(a)

(b)

3

Fig_6

Fig_7

Fig_8